# EUROPEAN PATENT SPECIFICATION

(11) **EP 0 724 380 B1**
(45) Date of publication and mention of the grant of the patent: **13.08.2003**
(21) Application number: 95116958.0
(22) Date of filing: 27.10.1995
(51) Int. Cl.: H05K 5/06

(54) **Waterproof casing structure for electronic equipment**
Gedichte Gehäusestruktur für elektronisches Gerät
Structure de boîtier étanche pour équipement électronique

(30) Priority: 27.01.1995 JP 1145195
(43) Date of publication of application: 31.07.1996
(60) Divisional application: 02021867.3
(73) Proprietor: MITSUBISHI DENKI KABUSHIKI KAISHA, Tokyo 100 (JP)
(72) Inventor: Saito, Koji, c/o Mitsubishi Denki K.K., Amagasaki-shi, Hyogo 661 (JP); Inubushi, Toshiya, c/o Mitsubishi Denki K.K., Amagasaki-shi, Hyogo 661 (JP)
(74) Representative: Füchsle, Klaus, Dipl.-Ing.

(56) References cited:
- EP-A- 0 392 631
- DE-A- 2 652 262
- FR-A- 1 131 300
- FR-A- 1 451 570
- US-A- 3 575 546
- US-A- 5 153 380

## Description

### BACKGROUND OF THE INVENTION

### FIELD OF THE INVENTION

The present invention relates to a waterproof casing structure for electronic equipment.

### DESCRIPTION OF THE RELATED ART

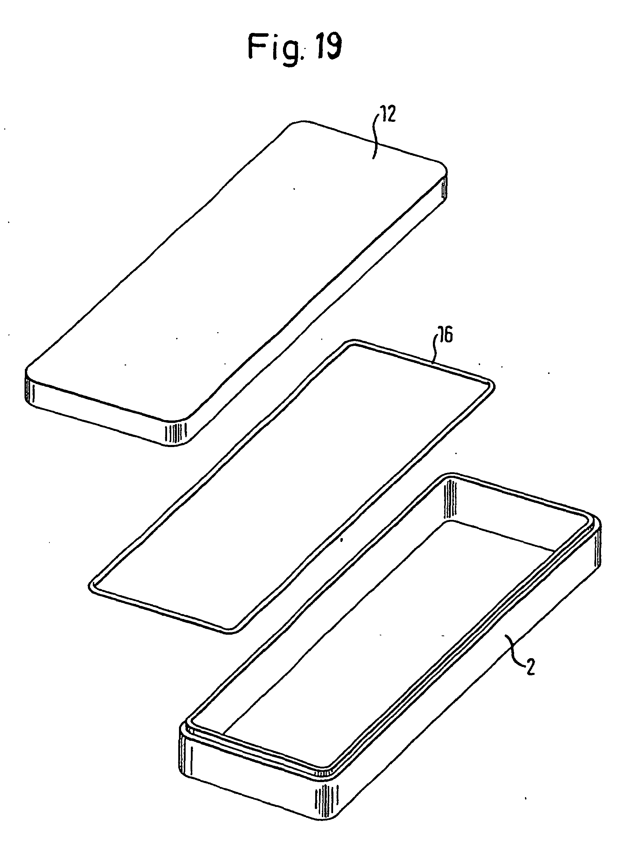

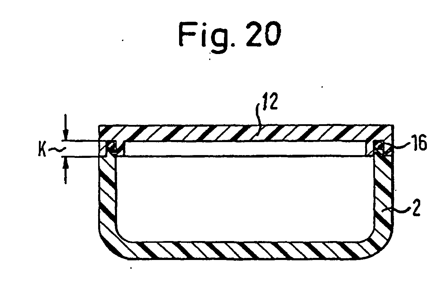

There is shown a conventional waterproof casing structure for electronic equipment in Fig. 19 and Fig. 22. Fig. 19 is a perspective view and Fig. 20 is a cross-sectional view of the casing of Fig. 19.
A box-shaped lower, first case member (2) and an upper, second case member 12 are engaged with each other as shown in Fig. 20. Between the first case member (2) and the second case member (12), an annular round rubber packing portion (16) of the second case member is held on the entire periphery of the engaging portion. The case members (2) and (12) are generally made of thermoplastic resin.

In this conventional waterproof structure, a groove portion for accommodating the waterproof packing portion (16) must be provided in the upper, second case member (12) and a projection to press the waterproof packing portion (16) is needed in the lower, first case member (2). Therefore, the overlapping distance designated as K in Fig. 20 adds thickness to the casing. This kind of structure makes it difficult to reduce the thickness of the casing, even when a reduced thickness is desired.
Further, if the casing is of a complicated form, the waterproof packing also has a complicated form, making it difficult to insert and assemble the waterproof packing.

Further, when the size of the casing is reduced, the thickness of diameter of the waterproof packing must also be reduced. However, such a waterproof packing having a small diameter may be readily deformed or broken when assembled.

### SUMMARY OF THE INVENTION

In view of the afore-mentioned problems, an object of the present invention is to provide a waterproof casing structure for electronic equipment which allows a reduction in the thickness of the casing.

Another object of the invention is to provide a waterproof casing structure in which a waterproof packing and a casing are formed as one unit so as to reduce the number of parts and simplify the assembly process.

A further object of the invention is to provide a manufacturing method suited for the waterproof casing structure.

According to the present invention there is provided a waterproof casing for electronic equipment, said casing comprising
- a first case member and
- a second case member detachably engaged with said first case member to form a casing for accommodation;
said second case member being receivable in the first case member and said second case member having a base portion and a packing portion provided at least on the periphery of said base portion, said packing portion having sliding contact with said first case member along an inner periphery of said first case member when the second case member is brought into detachable engagement with the first case member by insertion thereinto in a first direction, when a portion of the packing portion is bent along the inner periphery of the first case member and deflected in the opposite direction to the first direction.

In a preferred form, the first case member has a box-like form. The second case member has a plate form. The packing portion is shaped in a thin plate-like form which protrudes from peripheral end portion of the plate-formed second case member. The packing portion is brought into contact with an inner surface of the first case member along the direction of insertion of the second case member.

In another preferred form, the packing portion is a thin plate protruding from the end portion of the plate-formed second case member. The thin plate packing portion is attached on either side of the major surfaces of the plate-formed second case member.

In another preferred form, part of the second case member is formed as a box-like portion. The packing member thereof is provided on an end surface of the box-like portion at a contacting or butting side thereof. The packing member is brought into butting contact with an end surface of the first case member.

In another preferred form, the packing member protrudes from the end portion of the second case member in a direction which forms a predetermined angle with respect to the surface o the second case member.

In another preferred form, the second case member and the packing member are integrally formed as one unit.

In another preferred form, the first and second case members are formed of a thermoplastic resin, while the packing portion is made of a thermoplastic elastic member.

Other and further objects, features and advantages of the invention will appear more fully from the following description of preferred exemplary embodiments of the present invention.

### BRIEF DESCRIPTION OF THE DRAWINGS

The invention disclosed herein will be understood better with reference to the following drawings in which like reference numerals refer to like elements.
- Fig. 1: is a perspective view of a first embodiment of an electronic equipment casing according to the present invention.
- Fig. 2(a) and 2(b): are cross-sectional views of the electronic equipment casing taken along the line A-A of Fig. 1.
- Fig. 3(a) and 3(b): 12 are cross-sectional views of another embodiment of the electronic equipment casing according to the present invention.
- Fig. 4(a) and 4(b): are cross-sectional views of another embodiment of the electronic equipment casing according to the present invention
- Fig. 5(a) and 5(b): are cross-sectional views of another embodiment of the electronic equipment casing according to the present invention.
- Fig. 6: is an enlarged cross-sectional view of another embodiment of the electronic equipment casing according to the present invention.
- Fig. 7: is an enlarged cross-sectional view of another embodiment of the electronic equipment casing according to the present invention.
- Fig. 8: is a perspective view of another embodiment of the electronic equipment casing according to the present invention.
- Fig. 9: is a cross-sectional view of the electronic equipment casing taken along the line C-C of Fig. 8.
- Fig. 10: is a perspective view of another embodiment of the electronic-equipment casing according to the present invention.
- Fig. 11: is a perspective view of part of the electronic equipment casing shown in Fig. 10.
- Fig. 12: is a cross-sectional view of the electronic equipment casing taken along the line E-E of Fig. 10.
- Fig. 13: is a partial side view of the electronic equipment casing looking in the direction of arrow G in Fig. 10.
- Fig. 14: is a partial end view of the electronic equipment casing looking upwards from beneath the upper case (second case member) of Fig. 10.
- Fig. 15: is a cross-sectional view of the electronic equipment casing taken along the line F-F of Fig. 10.
- Fig. 16: is a cross-sectional view of the electronic equipment casing taken along the line H-H of Fig. 13.
- Fig. 17: is a cross-sectional view of the electronic equipment casing taken along the line J-J of Fig. 13.
- Fig. 18: is an enlarged cross-sectional view of another embodiment of the electronic equipment casing according to the present invention.
- Fig. 19: is a perspective view of a conventional electronic equipment casing.
- Fig. 20: is a cross-sectional view of the conventional electronic equipment shown in Fig. 19.

### DESCRIPTION OF THE PREFERRED EMBODIMENTS

This invention will be described in further detail by way of examples with reference to the accompanying drawings.

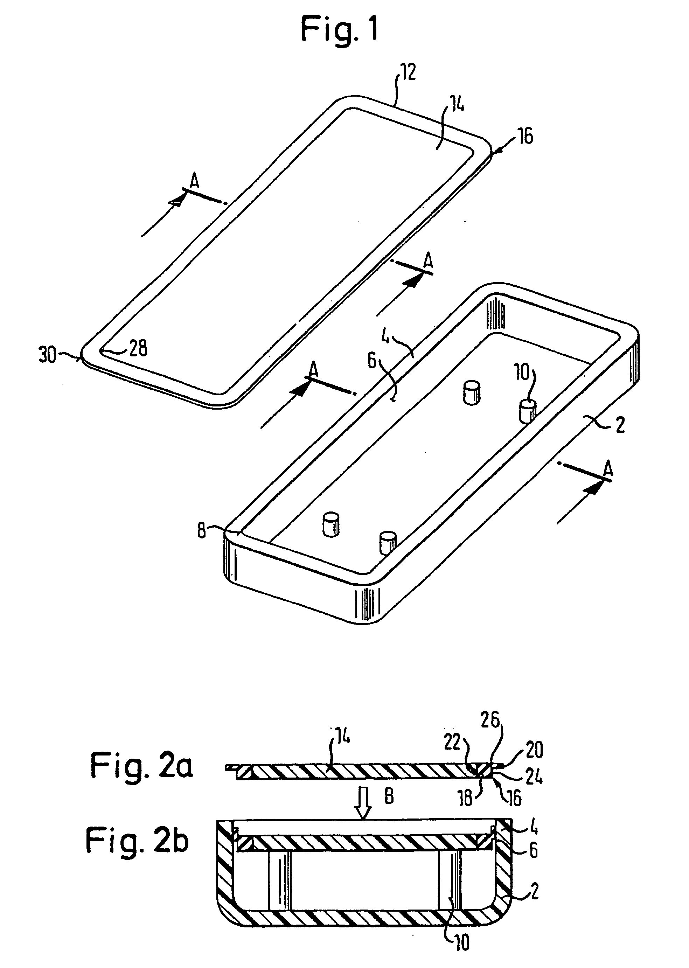

Fig. 1 is a perspective view of an embodiment of the electronic equipment casing according to the present invention. Figs. 2(a) and 2(b) are cross-sectional views taken along the line A-A of Fig. 1.
In the embodiment, the casing is divided into two parts, i.e. a lower case member (first case member) and an upper case member (second case member). In the Figures, there is shown a lower case member (2) in a box shape with an upside opening. The lower case member (2) has a rim portion (4), and its inner wall portion (6) is to receive an upper case member. The lower case member (2) has rounded portions (8) at its four corners. From an inner bottom surface of the lower case member (2), protrusions (10) extend to receive an upper case member which is to be described later. The lower case member (2) is generally made of a thermoplastic resin.

Facing the lower case member (2), there is shown an upper case member (12) composed of a plate member (base portion) (14) and a sealing or packing member (packing portion) (16). The plate member (14) is generally made of a thermoplastic resin and the packing member (16) is preferably made of a thermoplastic elastic resin formed integrally with the plate member (14).

The packing member (16) protrudes from the entire periphery of the end surface of the plate member (14) and is composed of a base portion (18) and a sheet portion (20) as is apparent in Fig. 2(a). The sheet portion (20) extends outwards from the base portion (18) in a thin plate form.. The base portion (18) of the packing member (16) is joined to the end surface of the plate member (14) at joint surface (22). The outer end surface (24) of the base portion (18) extends to the sheet portion (20) through round corner portion (26).

The upper surfaces of the plate member (14) and the packing member (16) are level. The base portion (18) of the packing member (16) has the same thickness as the plate member (14) and the sheet portion (20) is thinner than the base portion (18).

The plate member (14) has rounded portions (28) at the corners in the horizontal plane and the packing member (16) also has corresponding rounded portions (30).

The areal dimensions of the opening of the lower case member (2) are larger than the areal dimensions of the plate member (14) of the upper case member (12) and are smaller than the areal dimensions of the upper case member (12) with the packing member (16). In the same context, the areal dimensions of the rounded portions (8) of the lower case member (2) are greater than those of the rounded portions (28) and less than those of the rounded portions (30) of the upper case member (12).

In assembly or operation, the upper case member (12) is brought into engagement with the lower case member (2) in the direction as shown by the arrow B in Fig. 2(a). The upper case member (12) and the lower case member (2) are shown engaged in Fig. 2(b).

When the upper case member (12) and the lower case member (2) are brought into engagement, the outer end surface (24) of the packing member (16) fits along the entire periphery of the inner wall portion (6) of the lower case member (2).

Since the areal dimensions of the upper case member (12) including the packing member (16) are larger than the dimensions of the opening of the lower case member (2), the sheet portion (20) is bent along the inner wall portion (6) and is deflected in the opposite direction of the engagement. The sheet portion (20) thus applies a deflection load to the inner wall portion (6).

The sealing contact of the sheet portion (20) with the inner wall portion (6) prevents entry of water droplets into the casing from the outside. The force with which the sheet portion (20) is in contact with the inner wall portion (6) can be varied by varying the thickness of the sheet portion (20).

The round structure of the corner portion (26) of the packing member (16) prevents breakage of the sheet portion (20), even when the sheet portion (20) is bent and concentrated stress is applied to the corner.

The radius of the rounded portion (8) is adjustably chosen. If the radius of the rounded portion (8) is too small, the sheet portion (20) is irregularly bent and may not be suitably fitted along the wall portion (6). The larger the radius of the rounded portion (8) is, the more the sheet portion (20) is fitted at the rounded portion (30) along the inner wall (6).

To manufacture the electronic equipment casing of this invention, thermoplastic material is preferably used. To manufacture the upper case member (12), a thermoplastic resin as the material of the plate member (14) and a thermoplastic elastic resin as the material of the packing member (16) are heat bonded to each other by injection molding.

Alternatively, two-colour molding (double molding) is performed. That is, after the packing member (16) is inserted into an injection molding die of the plate member (14) or after the plate member (14) is inserted into an injection molding die of the packing member(16), the plate member (14) and the packing member (16) are heat bonded to each other to make them into one unit by, for example, injection molding.

In the waterproof structure of the casing according to the present invention, the thickness of the casing can be readily reduced, because the height or thickness of the upper case member (12) is not added on top of the lower case member (2) as is the case with the conventional casing shown in Figs. 21 and 22.

Further, since the packing member (16) is formed integrally with the plate member (14) in the upper case member (12), the number of parts can be reduced and the assembly can be simplified.

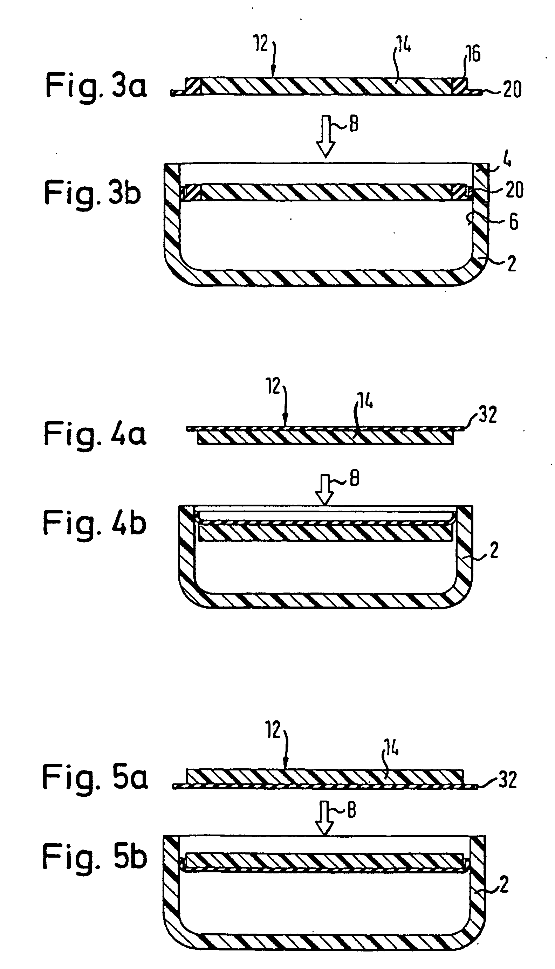

There is shown another embodiment of the invention in the cross-sectional view of Figs. 3(a) and 3(b).

In this embodiment, an upper case member (12) has a plate member (14) and a packing member (16) joined upside down compared with Figs. 2(a) and (2b). That is, the sheet portion (20) of the packing member (16) is extended at the lower surface of the plate member (14).

There is shown another embodiment of the invention in a cross-sectional view of Fig. 4(a) and Fig. 4(b).

In this embodiment, the upper case member (12) in Fig. 4(a) is brought into engagement with the lower case member (2) as shown in Fig. 4(b).

The upper case member (12) is composed of a plate member (14) and a packing portion (16) in the form of a sheet member (32) overlapping and integrally joined over the plate member (14). The sheet member (32) is larger in its areal dimensions than the plate member (14) and extends outward over the entire periphery of the plate member (14). The sheet member (32) is preferably made of a thermoplastic elastic resin.

The upper case member (12) in this embodiment can be manufactured by press molding or RIM molding. Therefore, the choice of manufacturing methods is increased. Thus, the sheet member (32) can be formed of rubber, such as silicone rubber.

There is shown another embodiment of the invention in the cross-sectional view of Figs. 5(a) and 5(b).

In this embodiment, an upper case member (12) has a packing sheet member (32) joined to the plate member (14) on the opposite side compared with Figs. 4(a) and 4(b). That is, the packing sheet member (32) is joined over the lower surface of the plate member (14).

This embodiment is advantageous for joining the sheet member (32) to the plate (14), since a force is applied to the sheet member (32) in a direction which secures the binding when upper and lower case members are engaged with each other.

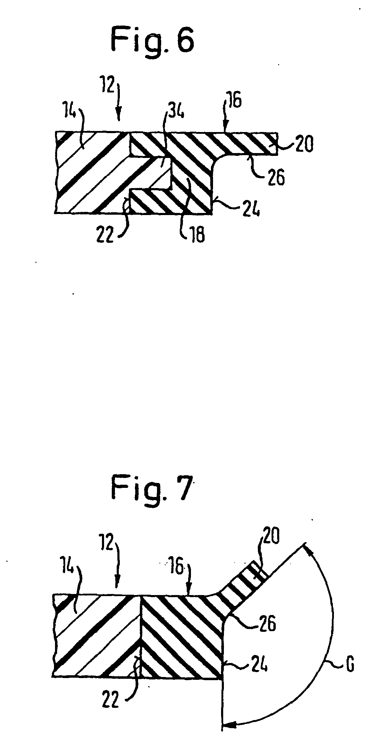

There is shown another embodiment of the invention in Fig. 6. This is an enlarged partial cross-sectional view of an upper case member (12).

A plate member (14) of the upper case member (12) has a protruding portion (34) which extends from the end surface (22) into the packing member (16). In this way, the packing member (16) is heat bonded to the plate member (14) through a larger interface so that the heat bonding strength between the packing member (16) and the plate member (14) is increased. Consequently, the packing member (16) does not readily peel off the plate member (14).

There is shown another embodiment of the invention in Fig. 7, which is an enlarged partial cross-sectional view of an upper case member.

In this embodiment, the packing member (16) of the upper case member (12) has an inclined sheet portion (20). The sheet portion (20) extends at an angle G with reference to the outer end surface (24) and the angle G can be more than 90 degrees and less than 180 degrees.

In this way, the resisting force of the sheet portion (20) can be adjusted. Further, the upper case member (12) can be readily brought into engagement with the lower case member (2).

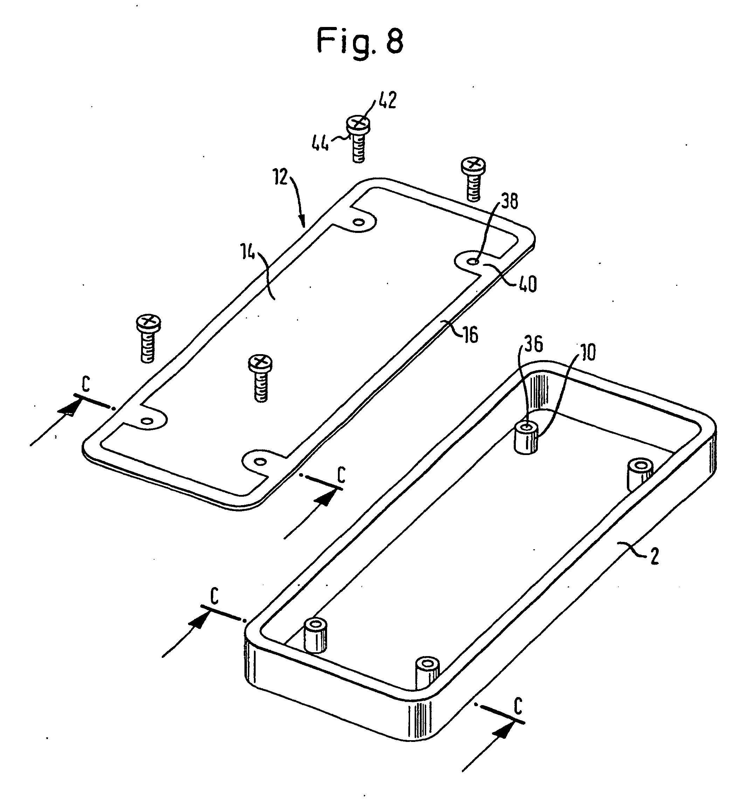

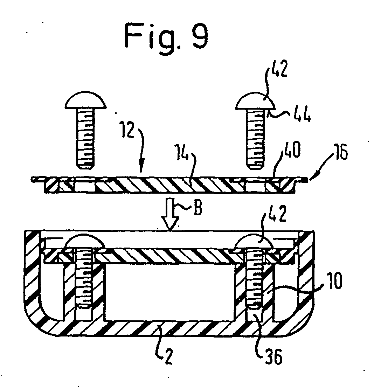

There is shown another embodiment of the invention in Fig. 8 and Fig. 9. This embodiment shows one way to secure the separate case parts, i.e. a lower case member and an upper case member. Fig. 9 is a sectional view taken along the line C-C of Fig. 8.

In this embodiment, the lower case member (2) has four projections (10) with threaded recesses (36). The upper case member (12) has four holes (38) which are coaxial with the corresponding recesses (36) of the lower case member (2). Each hole is surrounded by packing portion (40) which extends from the peripheral packing member (16) over the plate member (14). The packing portion (40) is level with the surface of the plate member (14) and is thinner than the plate member (14).

When the upper case member (12) is brought into engagement with the lower case member (2), each screw (42) is inserted into the hole (38) and screwed into the round hole (36) and the screw head portion (44) of the screw (42) presses the packing portion (40).

In this way, entry of water droplets is prevented from coming in through the round hole (38) of the upper case member (12). This embodiment provides a waterproof structure even when the electronic equipment casing is to be fixed by means of screws.

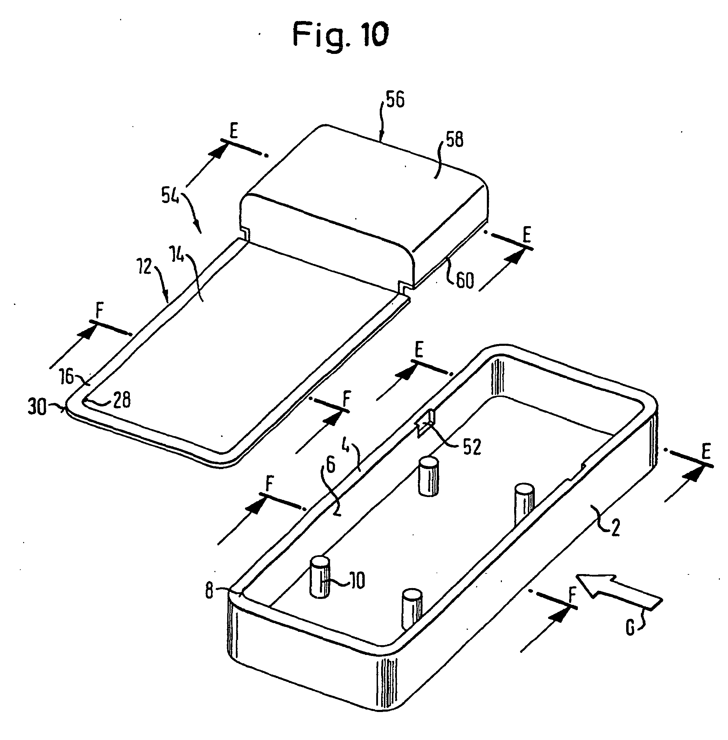

There is shown another embodiment in Fig. 10 through Fig. 17. A case is formed in such a manner that a battery pack can be mounted on a plate portion thereof.

In this embodiment, the lower case member (2) has a box shape with an upside opening and a pair of recesses (52) on the inner side (6) of the wall rim (4) as shown in the perspective view of Fig. 10.

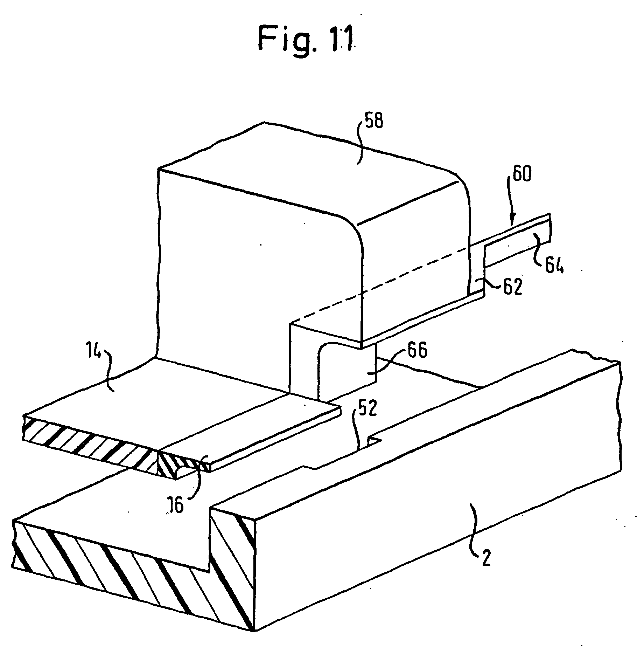

The upper case member (12) is composed of a box type portion (56) and a flat plate portion (54) as shown in Fig. 10. Fig. 11 is an enlarged partial perspective view of the joining area of the box type portion (56) and the flat plate portion (54).

The box type portion (56) has downside opening and is composed of a case portion (58) and a packing portion (60) joined thereto.

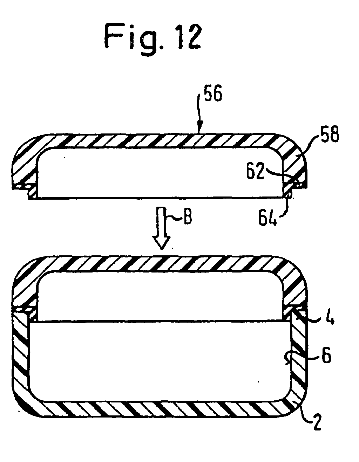

The packing portion (60) has a generally L-shape in cross section as shown in the cross-sectional view of Fig. 12, which is taken along the line E-E of Fig. 10. The packing portion (60) has a flat base portion (62) and a guide portion (64).

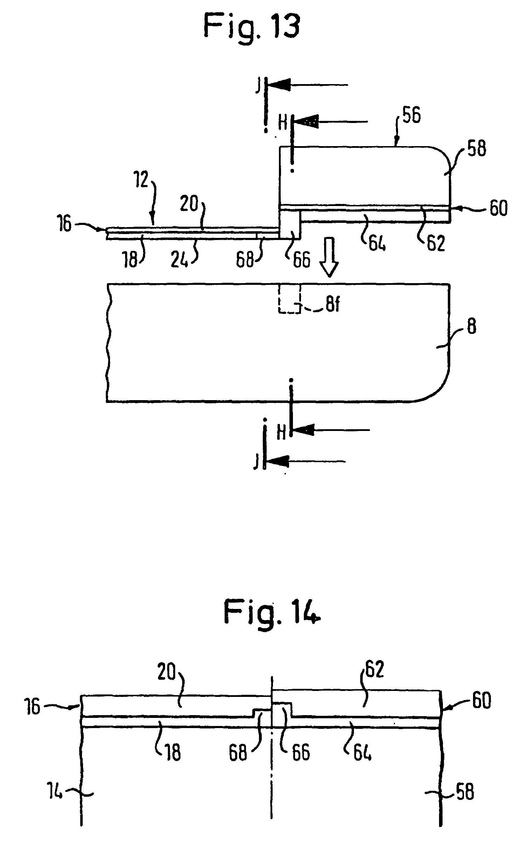

At the interface with the flat plate portion (54), the packing portion (60) has a projection (66) as shown in Fig. 11. The projection (66) is thicker than the guide portion (64) and long enough to reach the flat plate portion (54), as seen in Fig. 13, which is a partial side view taken in the direction of arrow G of Fig. 10, and as seen in Fig. 14, which is partial end view from the lower side of the upper case member (12).

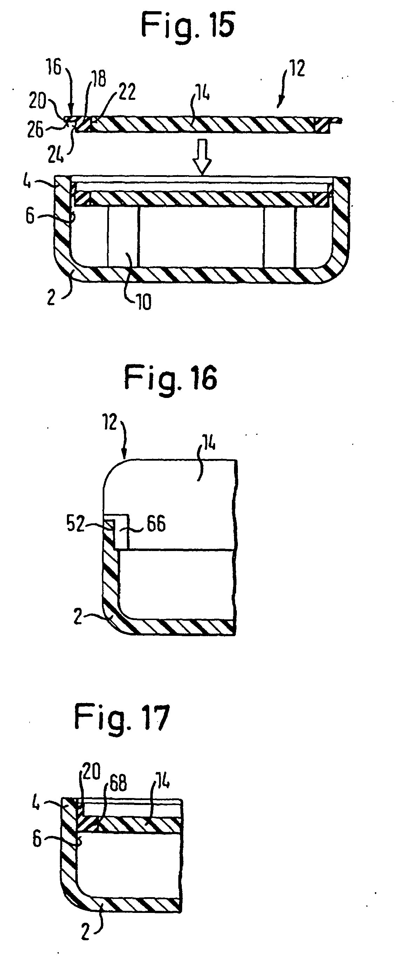

The flat plate portion (54) of the upper case member (12) generally has a similar shape as the previous embodiment such as explained with respect to Fig. 2(a), as shown in the cross-sectional view of Fig. 15 taken along the line F-F of Fig. 10. The flat plate portion (54) has a plate member (14) and packing member (16). At the interface with the box type portion (56), the packing member (16) has a projection (68), as seen in Fig. 13 and Fig. 14. The projection (68) is thicker than the base portion (18) but less thick than the projection (66) of the packing portion (60).

The packing portion (60) and the packing member (16) continuously extend with respect to each other and are formed integrally with the case portion (58) and plate member (14), respectively. The packing portion (60) and the packing member (16) are preferably made of a thermoplastic elastic resin.

The box type portion (56) of this embodiment operates as follows.

When the upper case member (12) is brought into engagement with the lower case member (2), the guide portion (64) of the packing portion (60) slides and contacts against the inner wall portion (6) of the lower case member (2) and the packing portion (60) is pressed against the lower case member (2), so that no space is formed.

The recess (52) has the same form as the projection (66) or a slightly smaller size than the projection (66) so that the projection (66) can be fit into this, and no space is formed therebetween, as shown in Fig. 16, which is a cross-sectional view taken along the line H-H of Fig. 13.

The flat plate portion (54) of the upper case member (12) works in a similar way as in the previous embodiment of Figs. 2(a) and 2(b), as shown in Fig. 15. The interface area with the box type portion (56), the projection (68) presses against the inner wall portion (6) as shown in Fig. 17, which is a cross-sectional view taken along the line J-J of Fig. 13, and no space is formed.

Along the interface between the box type portion (56) and flat plate portion (54), the projection (66) of the packing portion (60) and the projection (68) of the packing member (16) are formed continuously and integrally and pressed against the lower case member (2) so that no space is formed therebetween. Therefore, entry of water droplets into the casing from the outside is prevented.

This embodiment assures a waterproof structure for the electronic equipment casing where either of the separate case members is partially formed in a box-like shape from the necessity of design or due to the parts mounted in the casing.

Modifications of this embodiment of the flat plate portion (54) of the upper case member (12) can include waterproof structures shown in the previous embodiments.

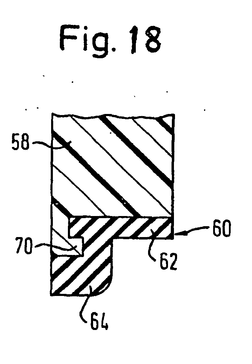

There is shown another embodiment of the invention in Fig. 18, which is an enlarged partial cross-sectional view of an upper case member. This embodiment is a modification of the box type portion (56) of the upper case member (12) of Fig. 10.

In this embodiment, a case portion (58) of a box type portion (56) has a protruding portion (70) which extends in a hook-like shape into the guide portion (64) of the packing portion (60).

In this way, the packing portion (60) is heat bonded to the case portion (58) through a larger interface, so that the heat bonding strength between the packing portion (60) and the case portion (58) is increased. Consequently, the packing portion (60) does not readily peel off the case portion (58).

It is understood that the foregoing description is of preferred embodiments of the disclosed device and that various changes and modifications may be made within the scope of the appended claims.

Reference signs in the claims are intended for better understanding only and shall not limit the scope of the claims.

## Claims

1. A waterproof casing for electronic equipment, said casing comprising
- a first case member (2) and
- a second case member (12) detachably engaged with said first case member to form a casing for accommodation;
said second case member (12) being receivable in the first case member (2) and said second case member (12) having a base portion (14) and a packing portion (16; 32) provided at least on the periphery of said base portion, said packing portion (16; 32) having sliding contact with said first case member along an inner periphery of said first case member (2) when the second case member (12) is brought into detachable engagement with the first case member (2) by insertion thereinto in a first direction (B), when a portion (20) of the packing portion is bent along the inner periphery of the first case member and deflected in the opposite direction to the first direction (B).

2. The waterproof casing according to claim 1, wherein said first case member (2) has a box form with an opening to receive said second case member.

3. The waterproof casing according to claim 1, wherein said second case member (12) has a plate-formed base portion (14) and a packing portion (16), and the packing portion has a packing base portion (18) joined to the periphery of the packing base portion and a thin plate portion (20) extending from the packing base portion (18).

4. The waterproof casing according to claim 1, wherein said second case member (12) has a plate-formed base portion (14) and a thin plate-formed packing portion (32 ) joined to either surface of the plate-formed base portion (14) and protruding from the periphery of the plate-formed base portion.

5. The waterproof casing according to claim 3, wherein the base portion (14) has a projection (34) extending into the packing base portion (18).

6. The waterproof casing according to claim 3, wherein said thin plate portion (20) of the packing portion (16) forms a predetermined angle of between 90° and 180° with respect to the surface of the plate-formed base portion (14) from which the thin plate portion extends.

7. A waterproof casing according to claim 1, wherein the base portion (14) and a packing portion (16) of the second case member (12) are integrally formed as one unit.

8. The waterproof casing according to claim 1, wherein said first case member (2) and the base portion (14) of said second case member (12) are formed of a thermoplastic resin, and the packing portion (16) of the said second case member (12) is formed of a thermoplastic elastic resin.

9. The waterproof casing according to claim 1, wherein said first case member (2) has projections (10) to receive said second case member (12), and said second case member (12) is fixed to the projections.

10. A waterproof casing according to one of the preceding claims, wherein
- said second case member (12) consists of a box-type portion (56) and a flat plate portion (54) joined together;
- the box-type portion (56) has a case portion (58) and a packing portion (60) provided at least on the peripheral of said case portion, and
- said packing portion (60) being capable of being brought into butting contact with said first case member.

## Patentansprüche

1. Wasserdichtes Gehäuse für elektronische Einrichtung,
wobei das Gehäuse folgendes aufweist:
- ein erstes Gehäuseelement (2) und
- ein zweites Gehäuseelement (12), das lösbar mit dem ersten Gehäuseelement in Eingriff steht, um ein Gehäuse zur Unterbringung auszubilden;
wobei das zweite Gehäuseelement (12) in dem ersten Gehäuseelement (2) aufnehmbar ist und das zweite Gehäuseelement (12) einen Basisabschnitt (14) und einen zumindest an dem Umfang bzw. an der Begrenzungsfläche des Basisabschnittes vorgesehenen Dichtungsabschnitt (16; 32) aufweist, wobei der Dichtungsabschnitt (16; 32) entlang eines inneren Umfangs des ersten Gehäuseelements (2) mit dem ersten Gehäuseelement in Gleitkontakt steht, wenn das zweite Gehäuseelement (12) durch Einführen dieses in eine erste Richtung (B) in lösbarem Eingriff mit dem ersten Gehäuseelement (2) gebracht wird, wenn ein Abschnitt (20) des Dichtungsabschnitts entlang des inneren Umfangs bzw. der inneren Begrenzungsfläche des ersten Gehäuseelements durchgebogen und in die zu der ersten Richtung (B) entgegengesetzte Richtung abgelenkt wird.

2. Wasserdichtes Gehäuse gemäß Anspruch 1, wobei das erste Gehäuseelement (2) eine Box-Form mit einer Öffnung zum Empfang des zweiten Gehäuseelements hat.

3. Wasserdichtes Gehäuse gemäß Anspruch 1, wobei das zweite Gehäuseelement (12) einen plattenförmigen Basisabschnitt (14) und einen Dichtungsabschnitt (16) aufweist und der Dichtungsabschnitt einen mit dem Umfang bzw. mit der Begrenzungsfläche des Dichtungsbasisabschnittes verbundenen Dichtungsbasisabschnitt (18) und einen dünnen Plattenabschnitt (20) hat, der sich von dem Dichtungsbasisabschnitt (18) erstreckt.

4. Wasserdichtes Gehäuse gemäß Anspruch 1, wobei das zweite Gehäuseelement (12) einen plattenförmigen Basisabschnitt (14) und einen dünnen plattenförmigen Dichtungsabschnitt (32) aufweist, der mit einer Oberfläche des plattenförmigen Basisabschnittes (14) verbunden ist und von der Begrenzungsfläche des plattenförmigen Basisabschnittes herausragt.

5. Wasserdichtes Gehäuse gemäß Anspruch 3, wobei der Basisabschnitt (14) einen Vorsprung hat, der sich in den Dichtungsbasisabschnitt (18) erstreckt.

6. Wasserdichtes Gehäuse gemäß Anspruch 3, wobei der dünne Plattenabschnitt (20) des Dichtungsabschnittes (16) einen bestimmten Winkel zwischen 90° und 180° in Bezug auf die Oberfläche des plattenförmigen Basisabschnittes (14), von welchem sich der dünne Plattenabschnitt erstreckt, ausbildet.

7. Wasserdichtes Gehäuse gemäß Anspruch 1, wobei der Basisabschnitt (14) und ein Dichtungsabschnitt (16) des zweiten Gehäuseelements (12) integral als eine Einheit ausgebildet sind.

8. Wasserdichtes Gehäuse gemäß Anspruch 1, wobei das erste Gehäuseelement (2) und der Basisabschnitt (14) des zweiten Gehäuseelements (12) aus thermoplastischem Kunstharz ausgebildet sind und wobei der Dichtungsabschnitt (16) des zweiten Gehäuseelements (12) aus einem elastischen thermoplastischen Kunstharz ausgebildet ist.

9. Wasserdichtes Gehäuse gemäß Anspruch 1, wobei das erste Gehäuseelement (2) Vorsprünge (10) aufweist, um das zweite Gehäuseelement (12) zu empfangen, und wobei das zweite Gehäuseelement (12) an den Vorsprüngen fixiert ist.

10. Wasserdichtes Gehäuse gemäß einem der vorhergehenden Ansprüche, wobei:
- sich das zweite Gehäuseelement (12) aus einem boxartigem Abschnitt (56) und einem Flachplatten-Abschnitt (54) zusammensetzt, die miteinander verbunden sind;
- der boxartige Abschnitt (56) einen Gehäuseabschnitt (58) und einen Dichtungsabschnitt (60), der zumindest an der Begrenzungsfläche des Gehäuseabschnittes vorgesehen ist, hat; und
- der Dichtungsabschnitt (60) ausgelegt ist, in Kuppenkontakt mit dem ersten Gehäuseelement gebracht zu werden.

## Revendications

1. Boîtier étanche pour équipement électronique, ledit boîtier comprenant
- un premier élément de coffret (2) et
- un second élément de coffret (12) mis en prise de manière détachable avec ledit premier élément de coffret pour former un boîtier pour réception dans celui-ci ;
ledit second élément de coffret (2) pouvant être reçu dans le premier élément de coffret (2) et ledit second élément de coffret (12) ayant une partie de base (14) et une partie de garniture d'étanchéité (16 ; 32) disposée au moins sur la périphérie de ladite partie de base, ladite partie de garniture d'étanchéité (16 ; 32) ayant un contact coulissant avec ledit premier élément de coffret le long d'une périphérie interne dudit premier élément de coffret (2) lorsque le second élément de coffret (12) est amené en prise de manière détachable avec le premier élément de coffret (2) par insertion dans celui-ci dans une première direction (B), lorsqu'une partie (20) de la partie de garniture de coffret est courbée le long de la périphérie interne du premier élément de coffret et déviée dans la direction opposée à la première direction (B).

2. Boîtier étanche selon la revendication 1, dans lequel ledit premier élément de coffret (2) présente une forme de boîte avec une ouverture pour recevoir ledit second élément de coffret.

3. Boîtier étanche selon la revendication 1, dans lequel ledit second élément de coffret (12) comporte une partie de base en plate-forme (14) et une partie de garniture d'étanchéité (16), et la partie de garniture d'étanchéité comporte une partie de base de garniture d'étanchéité (18) jointe à la périphérie de la partie de base de garniture d'étanchéité et une partie de plaque mince (20) s'étendant depuis la partie de base de garniture d'étanchéité (18).

4. Boîtier étanche selon la revendication 1, dans lequel ledit second élément de coffret (12) comporte une partie de base en plate-forme (14) et une partie de garniture d'étanchéité en forme de plaque mince (32) jointe à l'une ou l'autre surface de la partie de base en plate-forme (14) et dépassant depuis la périphérie de la partie de base en plate-forme.

5. Boîtier étanche selon la revendication 3, dans lequel la partie de base (14) comporte une saillie (34) s'étendant dans la partie de base de garniture d'étanchéité (18).

6. Boîtier étanche selon la revendication 3, dans lequel ladite partie de plaque mince (20) de la partie de garniture d'étanchéité (16) forme un angle prédéterminé situé entre 90° et 180° par rapport à la surface de la partie de base en plate-forme (14) à partir de laquelle s'étend la partie de plaque mince.

7. Boîtier étanche selon la revendication 1, dans lequel la partie de base (14) et une partie de garniture d'étanchéité (16) du second élément de coffret (12) sont formées solidairement comme une unité.

8. Boîtier étanche selon la revendication 1, dans lequel ledit premier élément de coffret (2) et la partie de base (14) dudit second élément de coffret (12) sont formés d'une résine thermoplastique, et la partie de garniture d'étanchéité (16) dudit second élément de coffret (12) est formée d'une résine élastique thermoplastique.

9. Boîtier étanche selon la revendication 1, dans lequel ledit premier élément de coffret (2) comporte des saillies (10) pour recevoir ledit second élément de coffret (12), et ledit second élément de coffret (12) est fixé aux saillies.

10. Boîtier étanche selon l'une quelconque des revendications précédentes, dans lequel
- ledit second élément de coffret (12) est constitué d'une partie de type boîte (56) et d'une partie de plaque plate (54) raccordées ensemble ;
- la partie de type boîte (56) comporte une partie de coffret (58) et une partie de garniture d'étanchéité (60) disposée au moins sur la périphérie de ladite partie de coffret, et
- ladite partie de garniture d'étanchéité (60) étant capable d'être amenée en contact de butée avec ledit premier élément de coffret.
